# FASCICULE DE BREVET EUROPEEN

(11) **EP 0 488 908 B1**
(45) Date de publication et mention de la délivrance du brevet: **08.11.1995**
(21) Numéro de dépôt: 91420409.4
(22) Date de dépôt: 19.11.1991
(51) Int. Cl.: G01R 31/02

(54) **Controleur permanent d'isolement**
Kontinuierlicher Isolationsmonitor
Permanent insulation monitor

(30) Priorité: 28.11.1990 FR 9014989
(43) Date de publication de la demande: 03.06.1992
(73) Titulaire: SCHNEIDER ELECTRIC SA, 92100 Boulogne Billancourt (FR)
(72) Inventeur: Masson, Erik, F-38050 Grenoble Cédex 9 (FR); Lassagne, Serge, F-38050 Grenoble Cédex 9 (FR); Magnard, Philippe, F-38050 Grenoble Cédex 9 (FR)
(74) Mandataire: Jouvray, Marie-Andrée

(56) Documents cités:
- US-A- 4 638 245
- 1986 IEEE INTERNATIONAL SYMPOSIUM ON ELECTROMAGNETIC COMPATIBILITY, San Diego,CA, 16-18 septembre 1986, Symposium Record, pages 428-434; D.S. DIXON et al.:"Reduction of EMI/EMP shield currents using an improved shield ground adapter"

## Description

L'invention concerne un contrôleur d'isolement comportant des moyens de connexion à la terre, des moyens de connexion à un réseau à contrôler, et des moyens pour appliquer entre la terre et le réseau un signal d'injection de valeur prédéterminée.

De manière classique, un contrôleur permanent d'isolement est destiné à contrôler l'isolement d'un réseau électrique à neutre isolé ou à neutre mis à la terre par une impédance. Dans ce but il comporte un générateur de tension appliquant entre le réseau et la terre un signal d'injection de valeur prédéterminée. Ce signal d'injection peut être constitué par une tension continue ou par un signal, sinusoïdal, carré ou pseudo-carré, de fréquence prédéterminée différente de la fréquence du réseau. Il en résulte un courant de fuite. Le contrôleur mesure l'isolement du réseau proportionnel à ce courant et fournit une alarme lorsque l'isolement est inférieur à un seuil prédéterminé. En pratique, une mesure représentative de l'isolement du réseau est constituée par la tension appliquée aux bornes du contrôleur.

L'invention a pour but un contrôleur d'isolement comportant une bonne immunité aux parasites, sans augmenter le prix du contrôleur.

Ce but est atteint par le fait qu'il comporte une plaque de circuit imprimé comportant un plan de masse, un boîtier métallique et des moyens de connexion du plan de masse au boîtier métallique, les moyens de connexion du contrôleur d'isolement à la terre étant fixés au boîtier et les moyens de connexion du contrôleur d'isolement au réseau sont constitués par une borne unique.

Selon un développement de l'invention, les moyens de connexion à la terre comportent un organe métallique fixé par rivetage au boîtier et destiné à être connecté par un conducteur de protection à la terre.

Dans un mode de réalisation préférentiel, les moyens de connexion du plan de masse au boîtier sont constitués par une équerre métallique fixée par rivetage au plan de masse de la plaque de circuit imprimé, et fixée au boîtier par une vis autotaraudeuse.

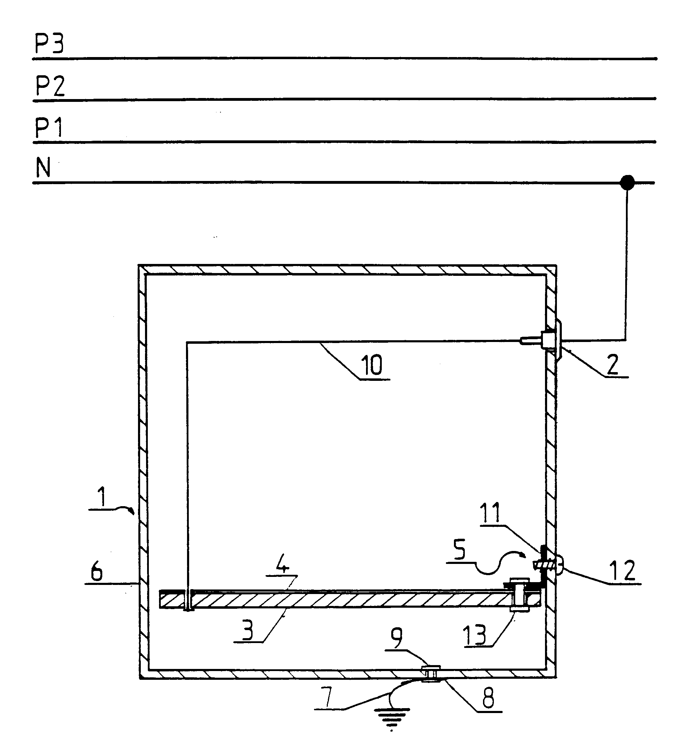

D'autres avantages et caractéristiques ressortiront plus clairement de l'exposé qui va suivre d'un mode particulier de réalisation de l'invention, donné à titre d'exemple non limitatif, et représenté sur la figure unique annexée.

La figure représente, de façon schématique, un contrôleur d'isolement selon l'invention associé au réseau à contrôler. Le réseau représenté est un réseau triphasé, P1,P2,P3, à neutre N isolé accessible. Le contrôleur comporte une borne 2, de type classique, de connexion au réseau. Cette borne est destinée à être connectée au neutre N du réseau.

Le contrôleur comporte une plaque de circuit imprimé 3 sur laquelle sont montés, de manière classique, les composants électroniques (non représentés) du contrôleur d'isolement. Cette plaque comporte, sur une face, un plan de masse 4 constituant la masse du circuit électronique. Ce plan de masse est connecté par des moyens 5 au boîtier 6, métallique, du contrôleur d'isolement. Le boîtier 6 est relié à la terre par un conducteur 7 de protection de l'appareil. Dans le mode de réalisation représenté le conducteur de protection 7 est connecté à un organe métallique 8, en forme d'oeillet, fixé au boîtier par un rivet 9.

Le circuit électronique comporte un circuit de mesure et de signalisation et un générateur produisant un signal d'injection de valeur prédéterminée. Ce signal est appliqué à la borne 2 de connexion au réseau par un conducteur 10.

Le contrôleur d'isolement 1 applique donc un signal d'injection de valeur prédéterminée entre la terre et le neutre N par l'intermédiaire du boîtier métallique 6. Celui-ci constitue une cage de Faraday qui permet d'immuniser le circuit électronique contre les parasites.La tenue aux parasites a été multipliée par 10 grâce à un contrôleur d'isolement du type représenté sur la figure.

Les moyens 5 de connexion du plan de masse 4 au boîtier 6 sont, sur la figure, constitués par une équerre métallique 11. L'équerre est fixée au boîtier par une vis auto-taraudeuse 12 et à la plaque de circuit imprimé par un rivet 13.

Pour des raisons de coût, le boîtier 6 est de préférence réalisé en tôle galvanisée. Le plan de masse 4 étant réalisée en cuivre recouvert d'un alliage d'étain-plomb (Sn Pb), l'équerre est en aluminium pur de manière à ne pas créer de problème de couple électro-chimique entre le plan de masse et le boîtier.

Bien entendu, l'invention n'est pas limitée au mode de réalisation particulier représenté. En particulier, l'équerre peut être remplacée par tout moyen permettant une bonne connexion électrique entre le plan de masse et le boîtier. Lorsque le neutre du réseau n'est pas accessible, la borne 2 du contrôleur d'isolement est connectée à l'un des conducteurs de phase (P1,P2,P3).

## Revendications

1. Contrôleur d'isolement comportant des moyens (7-9) de connexion à la terre, des moyens (2) de connexion à un réseau à contrôler, et des moyens pour appliquer entre la terre et le réseau un signal d'injection de valeur prédéterminée, contrôleur caractérisé en ce qu'il comporte une plaque de circuit imprimé (3) comportant un plan de masse (4), un boîtier métallique (6), et des moyens (5) de connexion du plan de masse au boîtier métallique, les moyens de connexion du contrôleur d'isolement à la terre étant fixés au boîtier et les moyens de connexion du contrôleur d'isolement au réseau étant constitués par une borne unique (2).

2. Contrôleur selon la revendication 1, caractérisé en ce que les moyens de connexion à la terre comportent un organe métallique (8) fixé par rivetage (9) au boîtier et destiné à être connecté par un conducteur de protection (7) à la terre.

3. Contrôleur selon l'une des revendications 1 et 2, caractérisé en ce que les moyens (5) de connexion du plan de masse au boîtier sont constitués par une équerre (11) métallique.

4. Contrôleur selon la revendication 3, caractérisé en ce que l'équerre (11) est fixée par rivetage au plan de masse (4) de la plaque (3) de circuit imprimé.

5. Contrôleur selon l'une des revendications 3 et 4, caractérisé en ce que l'équerre (11) est fixée au boîtier (6) par une vis autotaraudeuse (12).

6. Contrôleur selon l'une quelconque des revendications 1 à 5, caractérisé en ce que, le boîtier (6) étant en tôle galvanisée, les moyens (5) de connexion du plan de masse au boîtier sont en aluminium pur.

## Patentansprüche

1. Isolations-Überwachungseinrichtung mit Mitteln (7-9) zum Anschluß an Erde, Mitteln (2) zum Anschluß an ein zu überwachendes Netz sowie Mitteln zur Injizierung eines Prüfsignals mit einem bestimmten Wert zwischen Erde und Netz, dadurch gekennzeichnet, daß sie eine Leiterplatte (3) mit einer Massefläche (4), ein Metallgehäuse (6) sowie Mittel (5) zum Anschluß der Massefläche an das Gehäuse umfaßt, wobei die Mittel zum Anschluß der Isolations-Überwachungs-einrichtung an Erde am Gehäuse befestigt und die Mittel zum An-schluß der Isolations-Überwachungseinrichtung an das Netz als Einzel-klemme (2) ausgebildet sind.

2. Überwachungseinrichtung nach Anspruch 1, dadurch gekennzeichnet, daß die Mittel zum Anschluß an Erde ein Metallelement (8) umfassen, das mittels eines Niets (9) am Gehäuse befestigt ist und dazu dient, über einen Schutzleiter (7) an Erde angeschlossen zu werden.

3. Überwachungseinrichtung nach Anspruch 1 oder 2, dadurch gekenn-zeichnet, daß die Mittel zum Anschluß der Massefläche an das Ge-häuse aus einem Metallwinkel (11) bestehen.

4. Überwachungseinrichtung nach Anspruch 3, dadurch gekennzeichnet, daß der Winkel (11) auf die Massefläche (4) der Leiterplatte (3) der elektronischen Schaltung aufgenietet ist.

5. Überwachungseinrichtung nach Anspruch 3 oder 4, dadurch gekenn-zeichnet, daß der Winkel (11) über eine selbstschneidende Schraube (12) am Gehäuse (6) befestigt ist.

6. Überwachungseinrichtung nach irgendeinem der Ansprüche 1 bis 5, dadurch gekennzeichnet, daß das Gehäuse (6) aus verzinktem Blech und die Mittel (5) zum Anschluß der Massefläche an das Gehäuse aus reinem Aluminium bestehen.

## Claims

1. An insulation monitor comprising means for connecting to earth (7-9), means (2) for connecting to a power system to be monitored, and means for applying between the earth and the power system an input signal of preset value, a monitor characterized in that it comprises a printed circuit plate (3) comprising a ground plane (4), a metal case (6), and means (5) for connecting the ground plane to the metal case, the means for connecting the insulation monitor to earth being fixed to the case and the means for connecting the insulation monitor to the power system being formed by a single terminal (2).

2. The monitor according to claim 1, characterized in that the means for connecting to earth comprise a metal part (8) fixed by riveting (9) to the case and designed to be connected by a protective conductor (7) to earth.

3. The monitor according to one of the claims 1 and 2, characterized in that the means (5) for connecting the ground plane to the case are formed by a metal bracket (11).

4. The monitor according to claim 3, characterized in that the bracket (11) is fixed by riveting to the ground plane (4) of the printed circuit plate (3).

5. The monitor according to one of the claims 3 and 4, characterized in that the bracket (11) is fixed to the case (6) by a self-tapping screw (12).

6. The monitor according to one of the claims 1 to 5, characterized in that, the case (6) being made of galvanised metal plate, the means (5) for connecting the ground plane to the case are made of pure aluminium.
